# EUROPEAN PATENT SPECIFICATION

(11) **EP 1 902 476 B1**
(45) Date of publication and mention of the grant of the patent: **09.07.2014**
(21) Application number: 06786847.1
(22) Date of filing: 10.07.2006
(51) Int. Cl.: H01L 31/18, H01L 31/0392, H01L 31/04, H01L 51/00

(54) **METHOD OF TRANSFERRING PHOTOVOLTAIC CELLS**
VERFAHREN ZUM ÜBERTRAGEN VON PHOTOVOLTAISCHEN ZELLEN
PROCEDE DE TRANSFERT DE CELLULES PHOTOVOLTAIQUES

(30) Priority: 12.07.2005 US 698553 P
(43) Date of publication of application: 26.03.2008
(73) Proprietor: Merck Patent GmbH, 64293 Darmstadt (DE); Leonhard Kurz Stiftung & Co. KG, 90763 Fürth (DE)
(72) Inventor: BERKE, Howard, Hollis, New Hampshire 03049 (US)
(74) Representative: Louis Pöhlau Lohrentz
(86) International application number: PCT/US2006/026825
(87) International publication number: WO 2007/008861

(56) References cited:
- JP-A- 2003 128 490
- US-A- 5 942 048
- US-A1- 2003 005 954
- US-A1- 2004 031 520
- US-B1- 6 294 401
- US-B2- 6 531 704
- US-B2- 6 891 191
- US-B2- 6 900 382
- J.M. Kroon: "POLYMER BASED PHOTOVOLTAICS: NOVEL CONCEPTS, MATERIALS AND STATE-OF-THE ART EFFICIENCIES", , 1 January 2005 (2005-01-01), XP55007434, Retrieved from the Internet: URL:http://www.ecn.nl/docs/library/report/ 2005/rx05016.pdf [retrieved on 2011-09-16]
- HARALD HOPPE ET AL: "Organic solar cells: An overview", JOURNAL OF MATERIALS RESEARCH, vol. 19, no. 7, 1 July 2004 (2004-07-01), pages 1924-1945, XP55000317, ISSN: 0884-2914, DOI: 10.1557/JMR.2004.0252
- KAELIN M ET AL: "Low cost processing of CIGS thin film solar cells", SOLAR ENERGY, PERGAMON PRESS. OXFORD, GB, vol. 77, no. 6, 1 December 2004 (2004-12-01), pages 749-756, XP004661815, ISSN: 0038-092X, DOI: 10.1016/J.SOLENER.2004.08.015

## Description

### TECHNICAL FIELD

This disclosure relates to methods of preparing photovoltaic cells.

### BACKGROUND

Photovoltaic cells are commonly used to transfer energy in the form of light into energy in the form of electricity. A typical photovoltaic cell includes a photoactive material disposed between two electrodes. Generally, light passes through one or both of the electrodes to interact with the photoactive material to convert solar energy to electrical energy.

JP 2 003 128 490 relates to a method of transferring a photovoltaic cell from a first layer to a second layer.

### SUMMARY

In one aspect, the invention features a method as set out in claim 1 that includes contacting a die with a first layer, which supports a photovoltaic cell, so that the photovoltaic cell is transferred to a second layer by a stamping step.

Embodiments can include one or more of the following aspects.

The method can further include heating the die to at least 100°C (e.g., at least 150°C, at least 200°C, at least 250°C, or at least 300°C).

The contacting can include applying a pressure of at least 100 psi (e.g., at least 1,000 psi or at least 5,000 psi) to the die.

The method can further include disposing a release layer between the photovoltaic cell and the first layer. In some embodiments, the release layer includes a material selected from the group consisting of polyesters (e.g., aliphatic polyesters) or polyethylenes (e.g., low molecular weight polyethylenes).

The photovoltaic cell can be disposed between a contact layer and the first layer. In some embodiments, the contact layer can include an adhesive material (e.g., epoxies, polyurethanes, polyureas, styrene-acrylonitrile copolymers, polyethylene-based polymers, or polypropylene-based polymers).

The photovoltaic cell can include a photoactive material. In some embodiments, the photoactive material can include an electron donor material and an electron acceptor material. In some embodiments, the photoactive material can include a photosensitized interconnected nanoparticle material. In some embodiments, the photoactive material include amorphous silicon or copper indium gallium selenide (CuInGaSe₂; CIGS).

The electron acceptor material can include a material selected from the group consisting of fullerenes, inorganic nanoparticles, oxadiazoles, discotic liquid crystals, carbon nanorods, inorganic nanorods, polymers containing CN groups, polymers containing CF₃ groups, and combinations thereof.

The electron donor material can inclue a material selected from the group consisting of discotic liquid crystals, polythiophenes, polyphenylenes, polyphenylvinylenes, polysilanes, polythienylvinylenes, polyisothianaphthalenes, and combinations thereof.

The photosensitized interconnected nanoparticle material can include a material selected from the group consisting of selenides, sulfides, tellurides, titanium oxides, tungsten oxides, zinc oxides, zirconium oxides, and combinations thereof.

The die can contact the first layer at a surface on the die, at least a portion of which is curved.

The second layer can receive the photovoltaic cell at a surface on the second layer, at least a portion of which is curved.

The first or second layer can include a flexible substrate. In some embodiments, the first or second layer can include a polymer selected from the group consisting of polyethylene terephthalates, polyimides, polyethylene naphthalates, polymeric hydrocarbons, cellulosic polymers, polycarbonates, polyamides, polyethers, polyether ketones, and combinations thereof.

Other features and advantages will be apparent from the description, drawings and from the claims.

### DESCRIPTION OF DRAWINGS

FIG. 1 is a schematic representation of a hot stamping process of transferring a photovoltaic module to a flat substrate;
FIG.2 is a cross-sectional view of a photovoltaic module attached to a flat substrate;
FIG.3 is a schematic representation of a hot stamping process of transferring a photovoltaic module to a curved substrate;
FIG.4 is a cross-sectional view of a curved photovoltaic module attached to a curved substrate;
FIG. 5 is a cross-sectional view of an organic photovoltaic cell;
FIG. 6 is an elevational view of an embodiment of a mesh electrode;
FIG. 7 is a cross-sectional view of the mesh electrode of FIG 6;
FIG. 8 is a cross-sectional view of a portion of a mesh electrode;
FIG. 9 is a cross-sectional view of another organic photovoltaic cell;
FIG. 10 is a schematic of a system containing multiple photovoltaic cells electrically connected in series;
FIG. 11 is a schematic of a system containing multiple photovoltaic cells electrically connected in parallel; and
FIG. 12 is a cross-sectional view of a dye sensitized solar cell.
Like reference symbols in the various drawings indicate like elements.

### DETAILED DESCRIPTION

In general, this disclosure relates to methods of transferring a photovoltaic module or a photovoltaic cell.

According to the invention a photovoltaic module containing one or more photovoltaic cells is transferred to a layer by the following stamping method. A surface (e.g., a curved surface) of a die (e.g., a hot stamping die) is brought into contact with the back surface of a first layer (e.g., a flexible substrate). The front surface of the first layer is coated with a photovoltaic module. The front surface of the first layer is then brought into contact with a second layer, which serves as a receiving layer. When a pressure is applied to the die, the photovoltaic module on the front surface of the first layer transfers and adheres to the second layer. The pressure applied to the die can be at least 100 psi (e.g., at least 1,000 psi, at least 5,000 psi). In some embodiments, the front surface of the first layer can be brought into contact with the second layer before the die contacts the back surface of the first layer. In these embodiments, the photovoltaic module can be adhered to the second layer before being detached from the first layer.

In some embodiments, the die can be heated to a suitable temperature (e.g., at least about 100°C, at least about 150°C, at least about 200°C, at least about 250°C, at least about 300°C) to facilitate transfer of the photovoltaic module from the front surface of the first layer to the second layer.

In some embodiments, a release layer can be included between the photovoltaic module and the first layer to aid release of the photovoltaic module. The release layer can include a material that softens or melts at or below the temperature of the die during the stamping process. Examples of such materials include wax or a polymer with a low melting point (e.g., aliphatic polyesters or low molecular weight polyethylenes). The release layer can have a thickness at least about 0.1 micron (at least about 0.5 micron, at least about 1.0 micron) or at most about 50 microns (at most about 10 microns, at most about 5 microns). In some embodiments, the release layer softens or melts during the stamp process to facilitate the detachment of the photovoltaic module from the first layer. The photovoltaic module can be detached at the top, at the bottom, or at a place between the top and the bottom of the release layer.

In some embodiments, the photovoltaic module can be disposed between a contact layer and the release layer on the first layer. The contact layer can have a thickness at least about 0.1 micron (at least about 0.5 micron, at least about 1.0 micron) or at most about 50 microns (at most about 10 microns, at most about 5 microns). The contact layer can include an adhesive material. In general, any adhesive material capable of holding the photovoltaic module in place can be used in the contact layer. In some embodiments, the adhesive material is a heat-sensitive adhesive material, i.e., a material that becomes adhesive after being heated at a certain activation temperature (e.g., at most about 150°C, at most about 100°C, or at most about 50°C). Preferably, the activation temperature is the same as or lower than the temperature of the die used during the stamping process. Examples of heat-sensitive adhesive materials include epoxies, polyurethanes, polyureas, styrene-acrylonitrile copolymers, polyethylene-based polymers, or polypropylene-based polymers. Without wishing to be bound by theory, it is believed that the contact layer can facilitate the adhering of the photovoltaic module with the second layer. For example, when the die is heated during the stamping process, a heat-sensitive adhesive material in the contact layer becomes adhesive and then adheres the photovoltaic module to the second layer. In some embodiments, the adhesive material can include a fluorinated adhesive. The adhesive material can also be formed of a material that is transparent at the thickness used or can contain an electrically conductive adhesive.

In some embodiments, the photovoltaic module can include one or more photovoltaic cells, such as organic photovoltaic cells, dye sensitized solar cells (DSSCs), amorphous silicon solar cells, CIGS solar cells, and/or tandem cells.

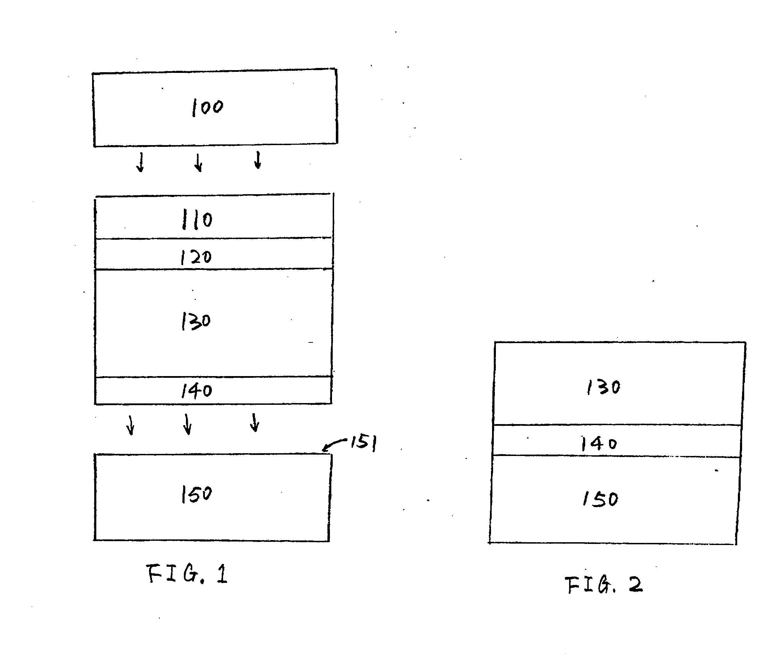

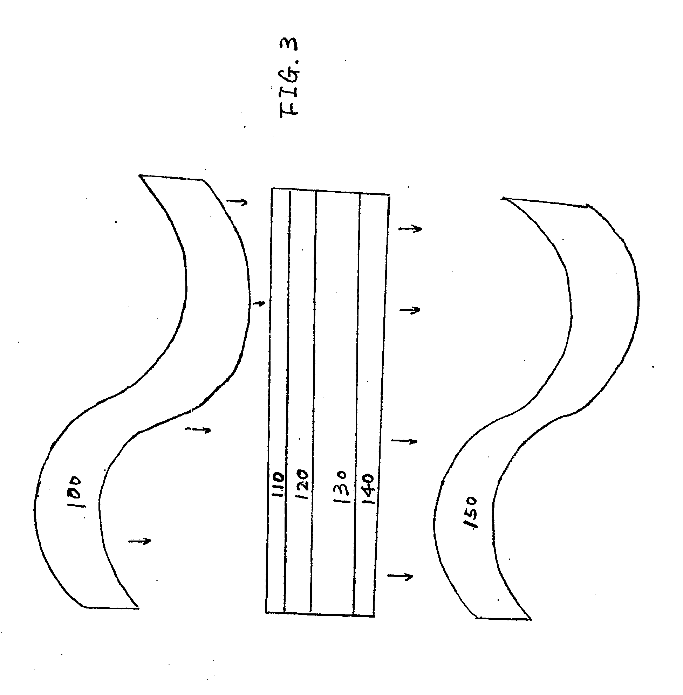

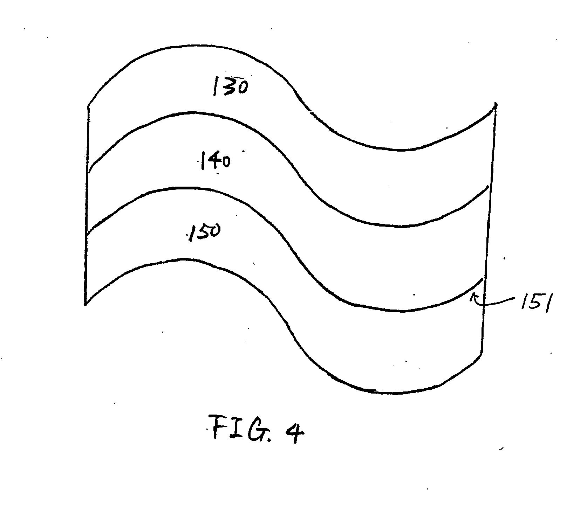

FIG. 1 is a schematic representation of a hot stamping process of transferring a photovoltaic module 130 from a flat substrate 110 to a flat receiving surface 151 of a substrate 150 by using a die 100. As shown in FIG. 1, photovoltaic module 130 is disposed between a release layer 120 and a contact layer 140. During the hot stamping process, die 100 is heated to a suitable temperature (e.g., at least about 100°C) and then brought into contact with substrate 110. After release layer 120 and contact layer 140 soften or melt, pressure (e.g., at least about 100 psi) is applied to die 100 to bring the contact layer 140 into contact with receiving surface 151 so that it is adhered to substrate 150. Photovoltaic module 130 can then be detached at release layer 120 from substrate 110 when die 100 is removed. FIG.2 shows a cross-sectional view of photovoltaic module 130 attached to substrate 150 through contact layer 140. FIG. 3 shows a similar process to that described in FIG. 1 except that both substrates 110 and 150 have curved surfaces. FIG. 4 shows a cross-sectional view of photovoltaic module 130 that is attached to substrate 150 through contact layer 140 and conforms to curved receiving surface 151.

In some embodiments, the methods described above can be used in a continuous manufacturing process, such as roll-to-roll or web processes. Examples of roll-to-roll processes have been described in, for example, U.S. Application Publication No. 2005-0263179.

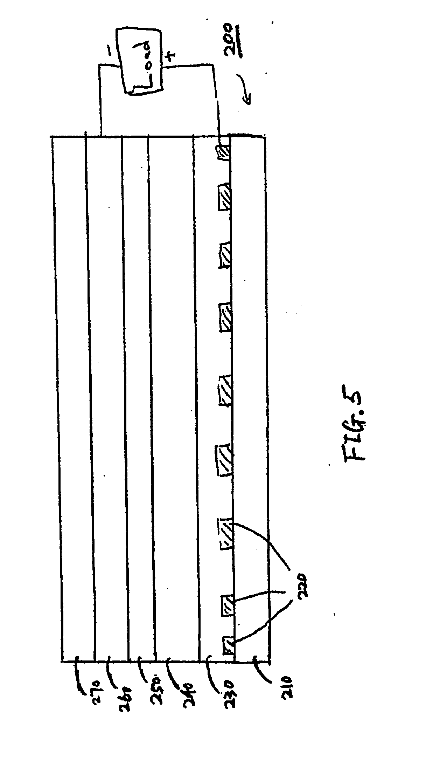

In some embodiments, the methods described above can be used to transfer an organic photovoltaic cell from one substrate to another substrate. FIG. 5 shows a cross-sectional view of an organic photovoltaic cell 200 that includes a transparent substrate 210, a mesh cathode 220, a hole carrier layer 230, a photoactive layer (containing an electron acceptor material and an electron donor material) 240, a hole blocking layer 250, an anode 260, and a substrate 270.

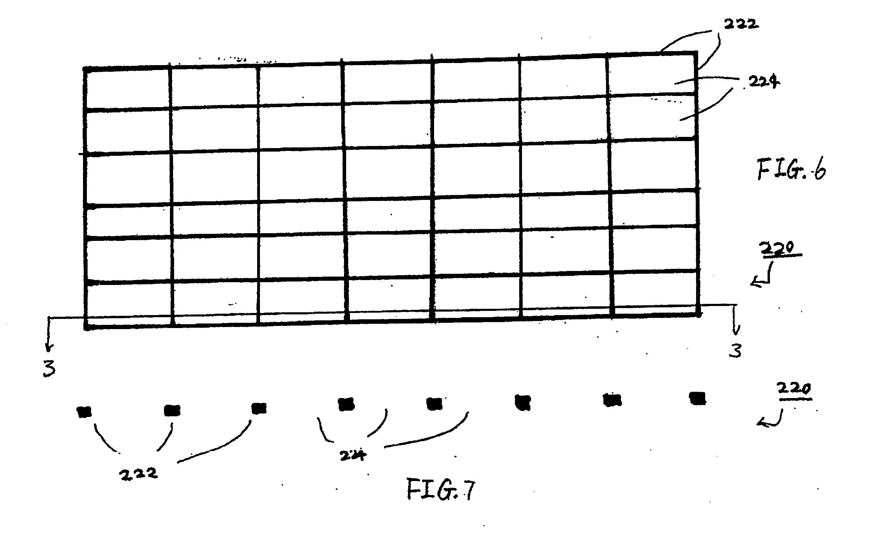

FIGs. 6 and 7 respectively show an elevational view and a cross-sectional of a mesh electrode. As shown in FIGs. 6 and 7, mesh cathode 220 includes solid regions 222 and open regions 224. In general, regions 222 are formed of electrically conducting material so that mesh cathode 220 can allow light to pass therethrough via regions 224 and conduct electrons via regions 222.

The area of mesh cathode 220 occupied by open regions 224 (the open area of mesh cathode 220) can be selected as desired. Generally, the open area of mesh cathode 220 is at least about 10% (e.g., at least about 20%, at least about 30%, at least about 40%, at least about 50%, at least about 60%, at least about 70%, at least about 80%) and/or at most about 99% (e.g., at most about 95%, at most about 90%, at most about 85%) of the total area of mesh cathode 220.

Mesh cathode 220 can be prepared in various ways. In some embodiments, mesh electrode can be stamped onto a layer (e.g., a substrate) as described above. In some embodiments, mesh cathode 220 is a woven mesh formed by weaving wires of material that form solid regions 222. The wires can be woven using, for example, a plain weave, a Dutch, weave, a twill weave, a Dutch twill weave, or combinations thereof. In certain embodiments, mesh cathode 220 is formed of a welded wire mesh. In some embodiments, mesh cathode 220 is an expanded mesh formed. An expanded metal mesh can be prepared, for example, by removing regions 224 (e.g., via laser removal, via chemical etching, via puncturing) from a sheet of material (e.g., an electrically conductive material, such as a metal), followed by stretching the sheet (e.g., stretching the sheet in two dimensions). In certain embodiments, mesh cathode 220 is a metal sheet formed by removing regions 224 (e.g., via laser removal, via chemical etching, via puncturing) without subsequently stretching the sheet.

In certain embodiments, solid regions 222 are formed entirely of an electrically conductive material (e.g., regions 222 are formed of a substantially homogeneous material that is electrically conductive). Examples of electrically conductive materials that can be used in regions 222 include electrically conductive metals, electrically conductive alloys and electrically conductive polymers. Exemplary electrically conductive metals include gold, silver, copper, aluminum, nickel, palladium, platinum and titanium. Exemplary electrically conductive alloys include stainless steel (e.g., 332 stainless steel, 316 stainless steel), alloys of gold, alloys of silver, alloys of copper, alloys of aluminum, alloys of nickel, alloys of palladium, alloys of platinum and alloys of titanium. Exemplary electrically conducting polymers include polythiophenes (e.g., poly(3,4-ethelynedioxythiophene) (PEDOT)), polyanilines (e.g., doped polyanilines), polypyrroles (e.g., doped polypyrroles). In some embodiments, combinations of electrically conductive materials are used. In some embodiments, solid regions 222 can have a resistivity less than about 3 ohm per square.

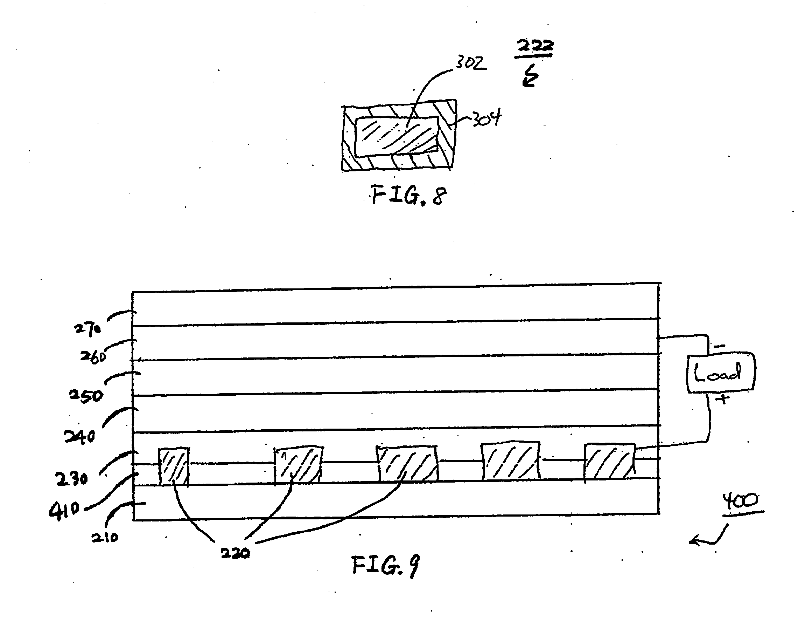

As shown in FIG. 8, in some embodiments, solid regions 222 are formed of a material 302 that is coated with a different material 304 (e.g., using metallization, using vapor deposition). In general, material 302 can be formed of any desired material (e.g., an electrically insulative material, an electrically conductive material, or a semiconductive material), and material 304 is an electrically conductive material. Examples of electrically insulative material from which material 302 can be formed include textiles, optical fiber materials, polymeric materials (e.g., a nylon) and natural materials (e.g., flax, cotton, wool, silk). Examples of electrically conductive materials from which material 302 can be formed include the electrically conductive materials disclosed above. Examples of semiconductive materials from which material 302 can be formed include indium tin oxide, fluorinated tin oxide, tin oxide, and zinc oxide. In some embodiments, material 302 is in the form of a fiber, and material 304 is an electrically conductive material that is coated on material 302. In certain embodiments, material 302 is in the form of a mesh (see discussion above) that, after being formed into a mesh, is coated with material 304. As an example, material 302 can be an expanded metal mesh, and material 304 can be PEDOT that is coated on the expanded metal mesh.

Generally, the maximum thickness of mesh cathode 220 (i.e., the maximum thickness of mesh cathode 220 in a direction substantially perpendicular to the surface of substrate 210 in contact with mesh cathode 220) should be less than the total thickness of hole carrier layer 230. Typically, the maximum thickness of mesh cathode 220 is at least 0.1 micron (e.g., at least about 0.2 micron, at least about 0.3 micron, at least about 0.4 micron, at least about 0.5 micron, at least about 0.6 micron, at least about 0.7 micron, at least about 0.8 micron, at least about 0.9 micron, at least about one micron) and/or at most about 10 microns (e.g., at most about nine microns, at most about eight microns, at most about seven microns, at most about six microns, at most about five microns, at most about four microns, at most about three microns, at most about two microns).

While shown in FIG. 6 as having a rectangular shape, open regions 224 can generally have any desired shape (e.g., square, circle, semicircle, triangle, diamond, ellipse, trapezoid, irregular shape). In some embodiments, different open regions 224 in mesh cathode 220 can have different shapes.

Although shown in FIG. 7 as having square cross-sectional shape, solid regions 222 can generally have any desired shape (e.g., rectangle, circle, semicircle, triangle, diamond, ellipse, trapezoid, irregular shape). In some embodiments, different solid regions 222 in mesh cathode 220 can have different shapes. In embodiments where solid regions 222 have a circular cross-section, the cross-section can have a diameter in the range of about 5 microns to about 200 microns. In embodiments where solid regions 222 have a trapezoid cross-section, the cross-section can have a height in the range of about 0.1 micron to about 5 microns and a width in the range of about 5 microns to about 200 microns.

In some embodiments, mesh cathode 220 is flexible (e.g., sufficiently flexible to be incorporated in photovoltaic cell 200 using a continuous, roll-to-roll manufacturing process). In certain embodiments, mesh cathode 220 is semi-rigid or inflexible. In some embodiments, different regions of mesh cathode 220 can be flexible, semi-rigid or inflexible (e.g., one or more regions flexible and one or more different regions semi-rigid, one or more regions flexible and one or more different regions inflexible).

In general, mesh electrode 220 can be disposed on substrate 210. In some embodiments, mesh electrode 220 can be partially embedded in substrate 210.

Substrate 210 is generally formed of a transparent material. As referred to herein, a transparent material is a material which, at the thickness used in a photovoltaic cell 200, transmits at least about 60% (e.g., at least about 70%, at least about 75%, at least about 80%, at least about 85%, at least about 90%, at least about 95%) of incident light at a wavelength or a range of wavelengths used during operation of the photovoltaic cell. Exemplary materials from which substrate 210 can be formed include polyethylene terephthalates, polyimides, polyethylene naphthalates, polymeric hydrocarbons, cellulosic polymers, polycarbonates, polyamides, polyethers, polyether ketones, and combinations thereof. In certain embodiments, the polymer can be a fluorinated polymer. In some embodiments, combinations of polymeric materials are used. In certain embodiments, different regions of substrate 210 can be formed of different materials.

In general, substrate 210 can be flexible, semi-rigid or rigid (e.g., glass). In some embodiments, substrate 210 has a flexural modulus of less than about 5,000 megaPascals (e.g., less than about 2,500 megaPascals or less than about 1,000 megaPascals). In certain embodiments, different regions of substrate 210 can be flexible, semi-rigid or inflexible (e.g., one or more regions flexible and one or more different regions semi-rigid, one or more regions flexible and one or more different regions inflexible).

Typically, substrate 210 is at least about one micron (e.g., at least about five microns, at least about 10 microns) thick and/or at most about 1,000 microns (e.g., at most about 500 microns thick, at most about 300 microns thick, at most about 200 microns thick, at most about 100 microns, at most about 50 microns) thick.

Generally, substrate 210 can be colored or non-colored. In some embodiments, one or more portions of substrate 210 is/are colored while one or more different portions of substrate 210 is/are non-colored.

Substrate 210 can have one planar surface (e.g., the surface on which light impinges), two planar surfaces (e.g., the surface on which light impinges and the opposite surface), or no planar surfaces. A non-planar surface of substrate 210 can, for example, be curved or stepped. In some embodiments, a non-planar surface of substrate 210 is patterned (e.g., having patterned steps to form a Fresnel lens, a lenticular lens or a lenticular prism).

Hole carrier layer 230 is generally formed of a material that, at the thickness used in photovoltaic cell 200, transports holes to mesh cathode 220 and substantially blocks the transport of electrons to mesh cathode 220. Examples of materials from which layer 230 can be formed include polythiophenes (e.g., PEDOT), polyanilines, polyvinylcarbazoles, polyphenylenes, polyphenylvinylenes, polysilanes, polythienylenevinylenes and/or polyisothianaphthanenes. In some embodiments, hole carrier layer 230 can include combinations of hole carrier materials.

In general, the distance between the upper surface of hole carrier layer 230 (i.e., the surface of hole carrier layer 230 in contact with active layer 240) and the upper surface of substrate 210 (i.e., the surface of substrate 210 in contact with mesh electrode 220) can be varied as desired. Typically, the distance between the upper surface of hole carrier layer 230 and the upper surface of mesh cathode 220 is at least 0.01 micron (e.g., at least about 0.05 micron, at least about 0.1 micron, at least about 0.2 micron, at least about 0.3 micron, at least about 0.5 micron) and/or at most about five microns (e.g., at most about three microns, at most about two microns, at most about one micron). In some embodiments, the distance between the upper surface of hole carrier layer 230 and the upper surface of mesh cathode 220 is from about 0.01 micron to about 0.5 micron.

Active layer 240 generally contains an electron acceptor material and an electron donor material.

Examples of electron acceptor materials include formed of fullerenes, oxadiazoles, carbon nanorods, discotic liquid crystals, inorganic nanoparticles (e.g., nanoparticles formed of zinc oxide, tungsten oxide, indium phosphide, cadmium selenide and/or lead sulphide), inorganic nanorods (e.g., nanorods formed of zinc oxide, tungsten oxide, indium phosphide, cadmium selenide and/or lead sulphide), or polymers containing moieties capable of accepting electrons or forming stable anions (e.g., polymers containing CN groups, polymers containing CF₃ groups). In some embodiments, the electron acceptor material is a substituted fullerene (e.g., C61-phenyl-butyric acid methyl ester; PCBM). In some embodiments, active layer 240 can include a combination of electron acceptor materials.

Examples of electron donor materials include discotic liquid crystals, polythiophenes, polyphenylenes, polyphenylvinylenes, polysilanes, polythienylvinylenes, polyisothianaphthalenes, and combinations thereof. In some embodiments, the electron donor material is poly(3-hexylthiophene). In certain embodiments, active layer 240 can include a combination of electron donor materials.

Generally, active layer 240 is sufficiently thick to be relatively efficient at absorbing photons impinging thereon to form corresponding electrons and holes, and sufficiently thin to be relatively efficient at transporting the holes and electrons to layers 230 and 250, respectively. In certain embodiments, layer 240 is at least 0.05 micron (e.g., at least about 0.1 micron, at least about 0.2 micron, at least about 0.3 micron) thick and/or at most about one micron (e.g., at most about 0.5 micron, at most about 0.4 micron) thick. In some embodiments, layer 240 is from about 0.1 micron to about 0.2 micron thick.

Hole blocking layer 250 is generally formed of a material that, at the thickness used in photovoltaic cell 200, transports electrons to anode 260 and substantially blocks the transport of holes to anode 260. Examples of materials from which layer 250 can be formed include LiF and metal oxides (e.g., zinc oxide, titanium oxide).

Typically, hole blocking layer 250 is at least 0.02 micron (e.g., at least about 0.03 micron, at least about 0.04 micron, at least about 0.05 micron) thick and/or at most about 0.5 micron (e.g., at most about 0.4 micron, at most about 0.3 micron, at most about 0.2 micron, at most about 0.1 micron) thick.

Anode 260 is generally formed of an electrically conductive material, such as one or more of the electrically conductive materials noted above. In some embodiments, anode 260 is formed of a combination of electrically conductive materials.

In general, substrate 270 can be identical to substrate 220. In some embodiments, substrate 270 can be different from substrate 220 (e.g., having a different shape or formed of a different material or a non-transparent material).

FIG. 9 shows a cross-sectional view of a photovoltaic cell 400 that includes an adhesive layer 410 between substrate 210 and hole carrier layer 230.

Generally, any material capable of holding mesh cathode 220 in place can be used in adhesive layer 410. In general, adhesive layer 410 is formed of a material that is transparent at the thickness used in photovoltaic cell 400. Examples of adhesives include epoxies and urethanes. Examples of commercially available materials that can be used in adhesive layer 410 include Bynel™ adhesive (DuPont) and 615 adhesive (3M). In some embodiments, layer 410 can include a fluorinated adhesive. In certain embodiments, layer 410 contains an electrically conductive adhesive. An electrically conductive adhesive can be formed of, for example, an inherently electrically conductive polymer, such as the electrically conductive polymers disclosed above (e.g., PEDOT). An electrically conductive adhesive can be also formed of a polymer (e.g., a polymer that is not inherently electrically conductive) that contains one or more electrically conductive materials (e.g., electrically conductive particles). In some embodiments, layer 410 contains an inherently electrically conductive polymer that contains one or more electrically conductive materials.

In some embodiments, the thickness of layer 410 (i.e., the thickness of layer 410 in a direction substantially perpendicular to the surface of substrate 210 in contact with layer 410) is less thick than the maximum thickness of mesh cathode 220. In some embodiments, the thickness of layer 410 is at most about 90% (e.g., at most about 80%, at most about 70%, at most about 60%, at most about 50%, at most about 40%, at most about 30%, at most about 20%) of the maximum thickness of mesh cathode 220. In certain embodiments, however, the thickness of layer 410 is about the same as, or greater than, the maximum thickness of mesh cathode 220.

In general, a photovoltaic cell having a mesh cathode can be manufactured as desired.

In some embodiments, a photovoltaic cell can be prepared as follows. Electrode 260 is formed on substrate 270 using conventional techniques, and hole-blocking layer 250 is formed on electrode 260 (e.g., using a vacuum deposition process or a solution coating process). Active layer 240 is formed on hole-blocking layer 250 (e.g., using a solution coating process, such as slot coating, spin coating or gravure coating). Hole carrier layer 230 is formed on active layer 240 (e.g., using a solution coating process, such as slot coating, spin coating or gravure coating). Mesh cathode 220 is partially disposed in hole carrier layer 230 (e.g., by a stamping method described above). Substrate 210 is then formed on mesh cathode 220 and hole carrier layer 230 using conventional methods.

In certain embodiments, a photovoltaic cell can be prepared as follows. Electrode 260 is formed on substrate 270 using conventional techniques, and hole-blocking layer 250 is formed on electrode 260 (e.g., using a vacuum deposition or a solution coating process). Active layer 240 is formed on hole-blocking layer 250 (e.g., using a solution coating process, such as slot coating, spin coating or gravure coating). Hole carrier layer 230 is formed on active layer 240 (e.g., using a solution coating process, such as slot coating, spin coating or gravure coating). Adhesive layer 410 is disposed on hole carrier layer 230 using conventional methods. Mesh cathode 220 is partially disposed in adhesive layer 410 and hole carrier layer 230 (e.g., by disposing mesh cathode 220 on the surface of adhesive layer 410, and pressing mesh cathode 220). Substrate 210 is then formed on mesh cathode 220 and adhesive layer 410 using conventional methods.

While the foregoing processes involve partially disposing mesh cathode 220 in hole carrier layer 230, in some embodiments, mesh cathode 220 is formed by printing the cathode material on the surface of hole carrier layer 230 or adhesive layer 410 to provide an electrode having the open structure shown in the figures. For example, mesh cathode 220 can be printed using stamping, dip coating, extrusion coating, spray coating, inkjet printing, screen printing, and gravure printing. The cathode material can be disposed in a paste which solidifies upon heating or radiation (e.g., UV radiation, visible radiation, IR radiation, electron beam radiation). The cathode material can be, for example, vacuum deposited in a mesh pattern through a screen or after deposition it may be patterned by photolithography.

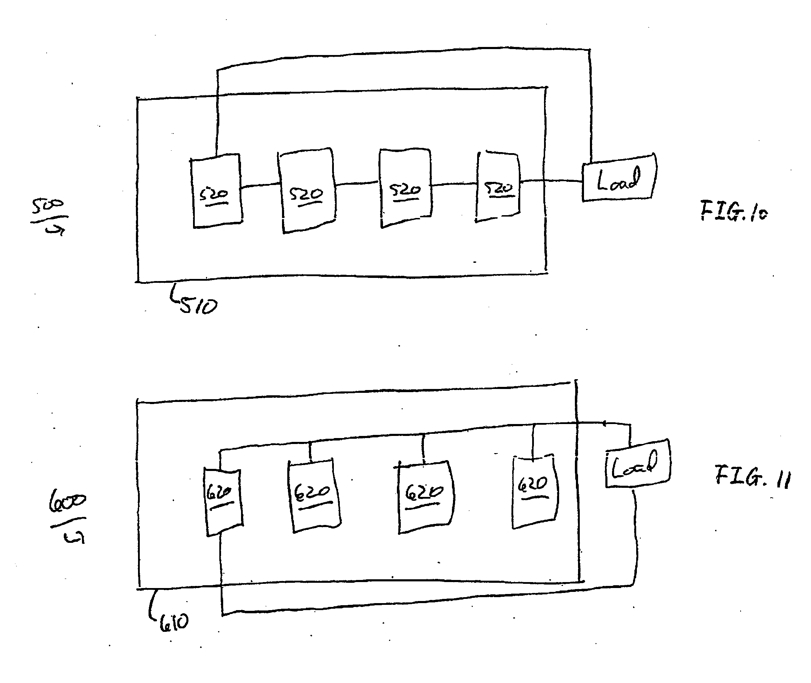

Multiple photovoltaic cells can be electrically connected to form a photovoltaic system. As an example, FIG. 10 is a schematic of a photovoltaic system 500 having a module 510 containing photovoltaic cells 520. Cells 520 are electrically connected in series, and system 500 is electrically connected to a load. As another example, FIG. 11 is a schematic of a photovoltaic system 600 having a module 610 that contains photovoltaic cells 620. Cells 620 are electrically connected in parallel, and system 600 is electrically connected to a load. In some embodiments, some (e.g., all) of the photovoltaic cells in a photovoltaic system can have one or more common substrates. In certain embodiments, some photovoltaic cells in a photovoltaic system are electrically connected in series, and some of the photovoltaic cells in the photovoltaic system are electrically connected in parallel.

In some embodiments, photovoltaic systems containing a plurality of photovoltaic cells can be fabricated using continuous manufacturing processes, such as roll-to-roll or web processes. In some embodiments, a continuous manufacturing process includes: forming a group of photovoltaic cell portions on a first advancing substrate; disposing an electrically insulative material between at least two of the cell portions on the first substrate; embedding a wire in the electrically insulative material between at least two photovoltaic cell portions on the first substrate; forming a group of photovoltaic cell portion on a second advancing substrate; combining the first and second substrates and photovoltaic cell portions to form a plurality of photovoltaic cells, in which at least two photovoltaic cells are electrically connected in series by the wire. In some embodiments, the first and second substrates can be continuously advanced, periodically advanced, or irregularly advanced.

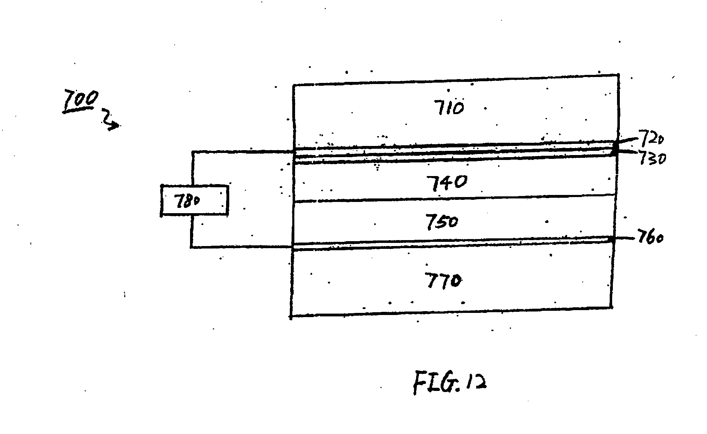

In some embodiments, the stamping methods described above can be used to print an electrode on a substrate for use in a DSSC. FIG. 12 is a cross-sectional view of DSSC 700 that includes a substrate 710, an electrode 720, a catalyst layer 730, a charge carrier layer 740, a photoactive layer 750, an electrode 760, a substrate 770, and an external load 780. Examples of DSSCs are discussed in U.S. Patent Application Serial Nos. 11/311,805 filed December 19, 2005 and 11/269,956 filed on November 9, 2005, the contents of which are hereby incorporated by reference.

In some embodiments, the stamping methods described above can be used to print an electrode on a substrate for use in a tandem cell. Examples of tandem photovoltaic cells are discussed in U.S. Patent Application Serial No. 10/558,878 and U.S. Provisional Application Serial Nos. 60/790,606, 60/792,635, 60/792,485, 60/793,442, 60/795,103, 60/797,881, and 60/798,258, the contents of which are hereby incorporated by reference.

While certain embodiments have been disclosed, other embodiments are also possible.

As one example, while cathodes formed of mesh have been described, in some embodiments a mesh anode can be used. This can be desirable, for example, when light transmitted by the anode is used. In certain embodiments, both a mesh cathode and a mesh anode are used. This can be desirable, for example, when light transmitted by both the cathode and the anode is used.

As another example, while embodiments have generally been described in which light that is transmitted via the cathode side of the cell is used, in certain embodiments light transmitted by the anode side of the cell is used (e.g., when a mesh anode is used). In some embodiments, light transmitted by both the cathode and anode sides of the cell is used (when a mesh cathode and a mesh anode are used).

As another example, while cathodes formed of mesh have been described, in some embodiments a non-mesh cathode can be used. In certain embodiments, both a non-mesh cathode and a non-mesh anode are used.

As a further example, while electrodes (e.g., mesh electrodes, non-mesh electrodes) have been described as being formed of electrically conductive materials, in some embodiments a photovoltaic cell may include one or more electrodes (e.g., one or more mesh electrodes, one or more non-mesh electrodes) formed of a semiconductive material. Examples of semiconductive materials include indium tin oxide, fluorinated tin oxide, tin oxide, and zinc oxide.

As an additional example, in some embodiments, one or more semiconductive materials can be disposed in the open regions of a mesh electrode (e.g., in the open regions of a mesh cathode, in the open regions of a mesh anode, in the open regions of a mesh cathode and the open regions of a mesh anode). Examples of semiconductive materials include tin oxide, fluorinated tin oxide, tin oxide and zinc oxide. Other semiconductive materials, such as partially transparent semiconductive polymers, can also be disposed in the open regions of a mesh electrode. For example, a partially transparent polymer can be a polymer which, at the thickness used in a photovoltaic cell, transmits at least about 60% (e.g., at least about 70%, at least about 75%, at least about 80%, at least about 85%, at least about 90%, at least about 95%) of incident light at a wavelength or a range of wavelengths used during operation of the photovoltaic cell. Typically, the semiconductive material disposed in an open region of a mesh electrode is transparent at the thickness used in the photovoltaic cell.

As another example, in certain embodiments, a protective layer can be applied to one or both of the substrates. A protective layer can be used to, for example, keep contaminants (e.g., dirt, water, oxygen, chemicals) out of a photovoltaic cell and/or to ruggedize the cell. In certain embodiments, a protective layer can be formed of a polymer (e.g., a fluorinated polymer).

As a further example, while certain types of photovoltaic cells have been described that have one or more mesh electrodes, one or more mesh electrodes (mesh cathode, mesh anode, mesh cathode and mesh anode) can be used in other types of photovoltaic cells as well. Examples of such photovoltaic cells include photoactive cells with an active material formed of amorphous silicon, cadmium selenide, cadmium telluride, copper indium sulfide, and copper indium gallium arsenide.

As an additional example, while described as being formed of different materials, in some embodiments materials 302 and 304 are formed of the same material.

As another example, although shown in FIG. 8 as being formed of one material coated on a different material, in some embodiments solid regions 222 can be formed of more than two coated materials (e.g., three coated materials, four coated materials, five coated materials, six coated materials).

Other embodiments are in the claims.

## Claims

1. A method of transferring a photovoltaic cell (130) from a first layer (110) to a second layer (150), the first layer having a back surface and a front surface, the front surface of the first layer (110) supporting a photovoltaic cell (130), and the second layer (150) being independent of the first layer (110), **characterised by** said method comprising the following steps:
- bringing a surface of a die (100) into contact with the back surface of the first layer (110);
- bringing the front surface of the first layer into contact with the second layer (150);
- performing a stamping step wherein pressure is applied to the die (100), causing the photovoltaic cell (130) to be transferred from the front surface of the first layer (110) to the second layer (150) so that the photovoltaic cell (130) is adhered to the second layer (150).

2. The method of claim 1, further comprising heating the die (100) to at least 100°C.

3. The method of claim 1, further comprising heating the die (100) to at least 300°C.

4. The method of claim 1, wherein the stamping step comprises applying a pressure of at least 6.897 bar (100 psi) to the die.

5. The method of claim 1, wherein the stamping step comprises applying a pressure of at least 68.97 bar (1,000 psi) to the die.

6. The method of claim 1, wherein the stamping step comprises applying a pressure of at least 344.8 bar (5,000 psi) to the die.

7. The method of claim 1, further comprising disposing a release layer (120) between the one photovoltaic cell and the first layer.

8. The method of claim 7, wherein the release layer (120) comprises polyesters or polyethylenes.

9. The method of claim 1, wherein the photovoltaic cell (130) is disposed between a contact layer (140) and the first layer (110).

10. The method of claim 9, wherein the contact layer (140) comprises an adhesive material.

11. The method of claim 9, wherein the adhesive material comprises epoxies, polyurethanes, polyureas, styrene-acrylonitrile copolymers, polyethylene-based polymers, or polypropylene-based polymers.

12. The method of claim 1, wherein the photovoltaic cell (130) comprises a photoactive material.

13. The method of claim 12, wherein the photoactive material comprises an electron donor material and an electron acceptor material.

14. The method of claim 13, wherein the electron acceptor material comprises a material selected from the group consisting of fullerenes, inorganic nanoparticles, oxadiazoles, discotic liquid crystals, carbon nanorods, inorganic nanorods, polymers containing CN groups, polymers containing CF₃ groups, and combinations thereof.

15. The method of claim 13, wherein the electron donor material comprises a material selected from the group consisting of discotic liquid crystals, polythiophenes, polyphenylenes, polyphenylvinylenes, polysilanes, polythienylvinylenes, and polyisothianaphtalenes.

16. The method of claim 12, wherein the photoactive material comprises a photosensitized interconnected nanoparticle material.

17. The method of claim 16, wherein the photosensitized interconnected nanoparticle material comprises a material selected from the group consisting of selenides, sulfides, tellurides, titanium oxides, tungsten oxides, zinc oxides, zirconium oxides, and combinations thereof.

18. The method of claim 12, wherein the photoactive material comprises amorphous silicon or CIGS.

19. The method of claim 1, wherein the die (100) contacts the first layer (110) at a surface on the die (100), at least a portion of which is curved.

20. The method of claim 1, wherein the second layer (150) receives the photovoltaic cell at a surface on the second layer (150), at least a portion of which is curved.

21. The method of claim 1, wherein the first layer (110) or the second layer (150) comprises a flexible substrate.

22. The method of claim 21, wherein the first layer (110) or the second layer (150) comprises a polymer selected from the group consisting of polyethylene terephthalates, polyimides, polyethylene naphthalates, polymeric hydrocarbons, cellulosic polymers, polycarbonates, polyamides, polyethers, polyether ketones, and combinations thereof.

## Patentansprüche

1. Verfahren zum Übertragen einer photovoltaischen Zelle (130) von einer ersten Schicht (110) auf eine zweite Schicht (150), wobei die erste Schicht eine hintere Fläche und eine vordere Fläche besitzt, die vordere Fläche der ersten Schicht (110) eine photovoltaische Zelle (130) trägt und die zweite Schicht (150) unabhängig von der ersten Schicht (110) ist, **dadurch gekennzeichnet, dass** das Verfahren die folgenden Schritte umfasst:
- Herstellen eines Kontakts zwischen einer Oberfläche eines Stempels (100) und der hinteren Fläche der ersten Schicht (110);
- Herstellen eines Kontakts zwischen der vorderen Fläche der ersten Schicht und der zweiten Schicht (150);
- Durchführen eines Pressschritts, wobei Druck auf den Stempel (100) ausgeübt wird, der bewirkt, dass die photovoltaische Zelle (130) von der vorderen Fläche der ersten Schicht (110) auf die zweite Schicht (150) übertragen wird, so dass die photovoltaische Zelle (130) an der zweiten Schicht (150) haftet.

2. Verfahren nach Anspruch 1, das ferner das Erwärmen des Stempels (100) auf mindestens 100 °C umfasst.

3. Verfahren nach Anspruch 1, das ferner das Erwärmen des Stempels (100) auf mindestens 300 °C umfasst.

4. Verfahren nach Anspruch 1, wobei der Pressschritt das Ausüben eines Drucks von mindestens 6,897 bar (100 psi) auf den Stempel umfasst.

5. Verfahren nach Anspruch 1, wobei der Pressschritt das Ausüben eines Drucks von mindestens 68,97 bar (1000 psi) auf den Stempel umfasst.

6. Verfahren nach Anspruch 1, wobei der Pressschritt das Ausüben eines Drucks von mindestens 344,8 bar (5000 psi) auf den Stempel umfasst.

7. Verfahren nach Anspruch 1, das ferner das Anordnen einer Trennschicht (120) zwischen der einen photovoltaischen Zelle und der ersten Schicht umfasst.

8. Verfahren nach Anspruch 7, wobei die Trennschicht (120) Polyester oder Polyethylene enthält.

9. Verfahren nach Anspruch 1, wobei die photovoltaische Zelle (130) zwischen einer Kontaktschicht (140) und der ersten Schicht (110) angeordnet ist.

10. Verfahren nach Anspruch 9, wobei die Kontaktschicht (140) ein klebendes Material enthält.

11. Verfahren nach Anspruch 9, wobei das klebende Material Epoxidharze, Polyurethanharze, Polyharnstoffe, Styrol-Acrylnitril-Copolymere, Polymere auf der Grundlage von Polyethylen oder Polymer auf der Grundlage von Polypropylen enthält.

12. Verfahren nach Anspruch 1, wobei die photovoltaische Zelle (130) ein photoaktives Material enthält.

13. Verfahren nach Anspruch 12, wobei das photoaktive Material ein Elektronendonatormaterial und ein Elektronenakzeptormaterial enthält.

14. Verfahren nach Anspruch 13, wobei das Elektronenakzeptormaterial ein Material enthält, das aus der Gruppe, die aus Fullerenen, anorganischen Nanopartikeln, Oxadiazolen, scheibenförmigen Flüssigkristallen, Kohlenstoffnanostäbchen, anorganischen Nanostäbchen, polymerhaltigen CN-Gruppen, polymerhaltigen CF₃-Gruppen und Kombinationen davon besteht, ausgewählt ist.

15. Verfahren nach Anspruch 13, wobei das Elektronendonatormaterial ein Material enthält, das aus der Gruppe, die aus scheibenförmigen Flüssigkristallen, Polythiophenen, Polyphenylenen, Polyphenylvinylen, Polysilanen, Polythienylvinylen und Polyisothianapthalinen besteht, ausgewählt ist.

16. Verfahren nach Anspruch 12, wobei das photoaktive Material ein photosensibilisiertes vernetztes Nanopartikelmaterial enthält.

17. Verfahren nach Anspruch 16, wobei das photosensibilisierte vernetzte Nanopartikelmaterial ein Material enthält, das aus der Gruppe, die aus Seleniden, Sulfiden, Telluriden, Titanoxiden, Wolframoxiden, Zinkoxiden, Zirkoniumoxiden und Kombinationen davon besteht, ausgewählt ist.

18. Verfahren nach Anspruch 12, wobei das photoaktive Material amorphes Silizium oder CIGS enthält.

19. Verfahren nach Anspruch 1, wobei der Stempel (100) mit der ersten Schicht (110) an einer Fläche auf dem Stempel (100), die mindestens zum Teil gekrümmt ist, in Kontakt ist.

20. Verfahren nach Anspruch 1, wobei die zweite Schicht (150) die photovoltaische Zelle an einer Fläche auf der zweiten Schicht (150), die mindestens zum Teil gekrümmt ist, aufnimmt.

21. Verfahren nach Anspruch 1, wobei die erste Schicht (110) oder die zweite Schicht (150) ein biegsames Substrat umfasst.

22. Verfahren nach Anspruch 21, wobei die erste Schicht (110) oder die zweite Schicht (150) ein Polymer enthalten, das aus der Gruppe, die aus Polyethylenterephtahalaten, Polyimiden, Polyethylennaphthalaten, polymeren Kohlenwasserstoffen, cellulosehaltigen Polymeren, Polycarbonaten, Polyamiden, Polyether, Polyetherketonen und Kombination davon besteht, ausgewählt ist.

## Revendications

1. Procédé de transfert d'une cellule photovoltaïque (130) à partir d'une première couche (110) vers une seconde couche (150), la première couche présentant une surface arrière et une surface avant, la surface avant de la première couche (110) supportant une cellule photovoltaïque (130) et la seconde couche (150) étant indépendante de la première couche (110), **caractérisé par le fait que** ledit procédé comprend les étapes suivantes :
de mise en contact d'une surface d'une matrice (100) avec la surface arrière de la première couche (110) ;
de mise en contact de la surface avant de la première couche avec la seconde couche (150) ;
d'exécution d'une étape de pressage dans laquelle une pression est appliquée sur la matrice (100), provoquant le transfert de la cellule photovoltaïque (130) à partir de la surface avant de la première couche (110) vers la seconde couche (150) de telle sorte que la cellule photovoltaïque (130) adhère à la seconde couche (150).

2. Procédé selon la revendication 1, comprenant en outre le chauffage de la matrice (100) à au moins 100°C.

3. Procédé selon la revendication 1, comprenant en outre le chauffage de la matrice (100) à au moins à 300°C.

4. Procédé selon la revendication 1, dans lequel l'étape de pressage comprend l'application d'une pression supérieure ou égale à 6,897 bars (100 psi) sur la matrice.

5. Procédé selon la revendication 1, dans lequel l'étape de pressage comprend l'application d'une pression supérieure ou égale à 68,97 bars (1000 psi) sur la matrice.

6. Procédé selon la revendication 1, dans lequel l'étape de pressage comprend l'application d'une pression supérieure ou égale à 344,8 bars (5000 psi) sur la matrice.

7. Procédé selon la revendication 1, comprenant en outre l'agencement d'une couche de séparation (120) entre la première cellule photovoltaïque et la première couche.

8. Procédé selon la revendication 7, dans lequel la couche de séparation (120) comprend des polyesters ou des polyéthylènes.

9. Procédé selon la revendication 1, dans lequel la cellule photovoltaïque (130) est disposée entre une couche de contact (140) et la première couche (110).

10. Procédé selon la revendication 9, dans lequel la couche de contact (140) comprend un matériau adhésif.

11. Procédé selon la revendication 9, dans lequel le matériau adhésif comprend des époxy, des polyuréthanes, des polyurées, des copolymères styrène-acrylonitrile, des polymères à base de polyéthylène, ou des polymères à base de polypropylène.

12. Procédé selon la revendication 1, dans lequel la cellule photovoltaïque (130) comprend un matériau photo-actif.

13. Procédé selon la revendication 12, dans lequel le matériau photo-actif comprend un matériau donneur d'électrons et un matériau receveur d'électrons.

14. Procédé selon la revendication 13, dans lequel le matériau receveur d'électrons comprend un matériau sélectionné à partir du groupe constitué par des fullerènes, des nanoparticules inorganiques, des oxadiazoles, des cristaux liquides discotiques, des nanotiges de carbone, des nanotiges inorganiques, des polymères contenant des groupes CN, des polymères contenant des groupes CF3, et des mélanges de ceux-ci.

15. Procédé selon la revendication 13, dans lequel le matériau donneur d'électrons comprend un matériau sélectionné à partir du groupe constitué par des cristaux liquide discotiques, des polythiophènes, des polyphénylènes, des polyphénylvinylènes, des polysilanes, des polythiénylvinylènes, et des polyisothianaphtalènes.

16. Procédé selon la revendication 12, dans lequel le matériau photo-actif comprend un matériau à base de nanoparticules interconnectées photosensibilisées.

17. Procédé selon la revendication 16, dans lequel le matériau à base de nanoparticules interconnectées photosensibilisées comprend un matériau sélectionné à partir du groupe constitué par des séléniures, des sulfures, des tellurures, des oxydes de titane, des oxydes de tungstène, des oxydes de zinc, des oxydes de zirconium et des mélanges de ceux-ci.

18. Procédé selon la revendication 12, dans lequel le matériau photo-actif comprend du silicium amorphe ou du CIGS (Cuivre-Indium-Sélénium-Gallium).

19. Procédé selon la revendication 1, dans lequel la matrice (100) entre en contact avec la première couche (110) au niveau d'une surface sur la matrice (100) dont au moins une partie est courbe.

20. Procédé selon la revendication 1, dans lequel la seconde couche (150) reçoit la cellule photovoltaïque au niveau d'une surface sur la seconde couche (150) dont au moins une partie est courbe.

21. Procédé selon la revendication 1, dans lequel la première couche (110) ou la seconde couche (150) comprend un substrat flexible.

22. Procédé selon la revendication 21, dans lequel la première couche (110) ou la seconde couche (150) comprend un polymère sélectionné à partir du groupe constitué par des polyéthylènes térephthalates, des polyimides, des polyéthylènes naphthalates, des hydrocarbures polymères, des polymères cellulosiques, des polycarbonates, des polyamides, des polyéthers, des polyéthers cétones, et des mélanges de ceux-ci.
